# EUROPEAN PATENT APPLICATION

(11) **EP 4 530 647 A2**
(43) Date of publication of application: **02.04.2025**
(21) Application number: 25156259.1
(22) Date of filing: 06.02.2025
(51) Int. Cl.: G01R 31/317, H03K 5/19

(54) **METHOD, APPARATUS AND DEVICE FOR MONITORING CLOCK NETWORK IN INTEGRATED CIRCUIT**

(30) Priority: 07.02.2024 CN 202410175794
(71) Applicant: Beijing Horizon Information Technology Co., Ltd., Beijing 100094 (CN)
(72) Inventor: YANG, Ruiqi, Beijing, 100094 (CN); LI, Wenxing, Beijing, 100094 (CN); LI, Jing, Beijing, 100094 (CN); CHEN, Chen, Beijing, 100094 (CN)
(74) Representative: Epping - Hermann - Fischer

(57) **Abstract**

This disclosure discloses a method, apparatus and a device for monitoring a clock network in an integrated circuit. The method includes: monitoring a clock frequency status of a first clock node in a clock network in the integrated circuit; detecting a clock running status of a second clock node in the clock network; determining a running status of the clock network based on the clock frequency status of the first clock node and the clock running status of the second clock node. According to this disclosure, clock frequency status monitoring can be performed on only some clock nodes in the clock network, while clock running status detection can be performed on other clock nodes. The clock running status indicates whether the clock node is toggling normally. According to this disclosure, resource consumption for clock monitoring can be effectively reduced while full-coverage monitoring for clocks in the clock network is supported.

## Description

### FIELD OF THE INVENTION

This disclosure relates to technologies of semiconductors, and in particular, to a method, an apparatus and a device for monitoring a clock network in an integrated circuit,.

### BACKGROUND OF THE INVENTION

In terminal devices such as a vehicle-mounted terminal and a mobile terminal, to improve running efficiency of an integrated circuit such as a chip, a clock in the integrated circuit usually adopts a network (MESH) structure, which may also be referred to as a clock network. The clock network may include multiple clock nodes, so as to provide clocks for various circuit modules and on-chip clock controllers (OCCs) in the integrated circuit. To ensure functional safety of the integrated circuit, it is very important to monitor each clock node in the clock network. In related technologies, full-coverage monitoring for the clock network is usually achieved by monitoring clock frequency of each clock node in the clock network. However, this full-coverage monitoring mode requires a large amount of on-chip resources.

### SUMMARY OF THE INVENTION

To resolve the foregoing technical problem of large resource consumption in clock monitoring, embodiments of this disclosure provide a clock network monitoring method and apparatus in an integrated circuit, and a device, to effectively reduce the resource consumption of clock monitoring.

According to a first aspect of this disclosure, a method for monitoring a clock network in an integrated circuit is provided, including: monitoring a clock frequency status of a first clock node in a clock network in the integrated circuit; detecting a clock running status of a second clock node in the clock network; and determining a running status of the clock network based on the clock frequency status of the first clock node and the clock running status of the second clock node.

According to a second aspect of this disclosure, an apparatus for monitoring a clock network in an integrated circuit is provided, including: a clock frequency monitoring module, configured to monitor a clock frequency status of a first clock node in a clock network in the integrated circuit; a clock running detection module, configured to detect a clock running status of a second clock node in the clock network; and a processing module connected to the clock frequency monitoring module and the clock running detection module, respectively, being configured to determine a running status of the clock network based on the clock frequency status of the first clock node and the clock running status of the second clock node.

According to a third aspect of this disclosure, a computer readable storage medium is provided. The storage medium stores a computer program, and the computer program is used for implementing the method according to any one of the foregoing embodiments of this disclosure.

According to a fourth aspect of this disclosure, an electronic device is provided. The electronic device includes: a processor; and a memory configured to store processor-executable instructions. The processor is configured to read the executable instructions from the memory, and execute the instructions to implement the method according to any one of the foregoing embodiments of this disclosure. Alternatively, the electronic device includes the apparatus according to any one of the foregoing embodiments of this disclosure.

Based on the clock network monitoring method and apparatus in an integrated circuit, and the device that are provided in the embodiments of this disclosure, the clock frequency status of the first clock node in the clock network in the integrated circuit may be monitored, and the clock running status of the second clock node in the clock network may be detected, so that the running status of the clock network may be determined based on the clock frequency status of the first clock node and the clock running status of the second clock node. According to method in the embodiments of this disclosure, clock frequency status monitoring may be performed on only some clock nodes (for example, one or more first clock nodes) in the clock network, while clock running status detection may be performed on other clock nodes. The clock running status indicates whether the clock node is toggling normally. Compared to the clock frequency status monitoring, the clock running status detection can be achieved with fewer on-chip resources. Therefore, according to the method in the embodiments of this disclosure, resource consumption for clock monitoring may be effectively reduced while full-coverage monitoring for clocks in the clock network is supported. This helps to resolve a problem of large resource consumption in a full-coverage monitoring mode in related technologies.

### BRIEF DESCRIPTION OF THE DRAWINGS

FIG. 1 is an exemplary application scenario of a method for monitoring a clock network in an integrated circuit according to this disclosure;
FIG. 2 is a schematic flowchart of a method for monitoring a clock network in an integrated circuit according to an exemplary embodiment of this disclosure;
FIG. 3 is a schematic flowchart of a method for monitoring a clock network in an integrated circuit according to another exemplary embodiment of this disclosure;
FIG. 4 is a schematic flowchart of a method for monitoring a clock network in an integrated circuit according to still another exemplary embodiment of this disclosure;
FIG. 5 is a flow block diagram of detecting a clock running status according to an exemplary embodiment of this disclosure;
FIG. 6 is a schematic diagram of a structure of an apparatus for monitoring a clock network in an integrated circuit according to an exemplary embodiment of this disclosure;
FIG. 7 is a schematic diagram of a structure of an apparatus for monitoring a clock network in an integrated circuit according to another exemplary embodiment of this disclosure;
FIG. 8 is a schematic diagram of a structure of an apparatus for monitoring a clock network in an integrated circuit according to still another exemplary embodiment of this disclosure;
FIG. 9 is a schematic diagram of a structure of an apparatus for monitoring a clock network in an integrated circuit according to an exemplary implementation in an exemplary embodiment of this disclosure;
FIG. 10 is a schematic diagram of a structure of a clock running detection module 52 according to an exemplary implementation in an exemplary embodiment of this disclosure; and
FIG. 11 is a diagram of a structure of an electronic device according to an embodiment of this disclosure.

### DETAILED DESCRIPTION OF THE EMBODIMENTS

To explain this disclosure, exemplary embodiments of this disclosure are described below in detail with reference to accompanying drawings. Obviously, the described embodiments are merely a part, rather than all of embodiments of this disclosure. It should be understood that this disclosure is not limited by the exemplary embodiments.

It should be noted that unless otherwise specified, the scope of this disclosure is not limited by relative arrangement, numeric expressions, and numerical values of components and steps described in these embodiments.

### Overview of this disclosure

In a process of implementing this disclosure, the inventor finds that in terminal devices such as a vehicle-mounted terminal and a mobile terminal, to improve operational efficiency of an integrated circuit such as a chip, a clock in the integrated circuit usually adopts a network (MESH) structure, which may also be referred to as a clock network. The clock network may include multiple clock nodes, so as to provide clocks for various circuit modules and on-chip clock controllers (OCCs) in the integrated circuit. To ensure functional safety of the integrated circuit, it is very important to monitor each clock node in the clock network. In related technologies, full-coverage monitoring for the clock network is usually achieved by monitoring clock frequency of each clock node in the clock network. However, this full-coverage monitoring mode requires a large amount of on-chip resources.

### Exemplary overview

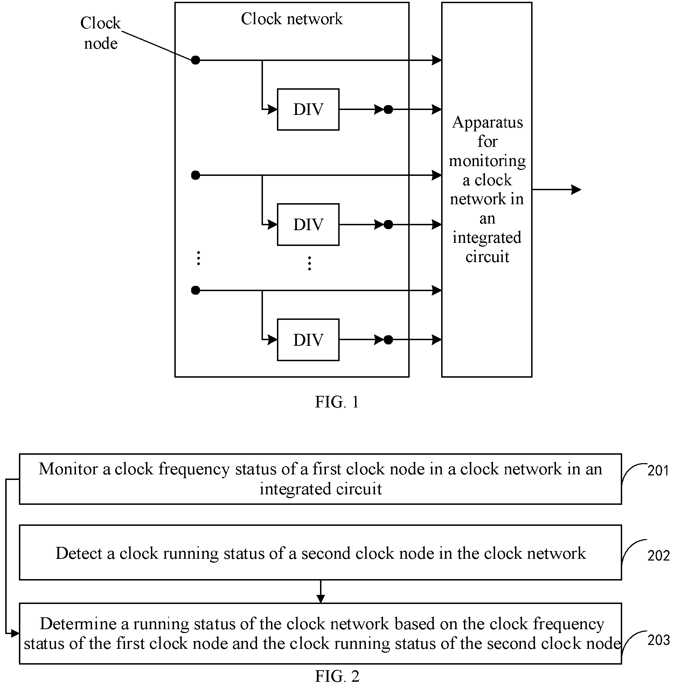

FIG. 1 is an exemplary application scenario of a method for monitoring a clock network in an integrated circuit according to this disclosure. As shown in FIG. 1, a clock network may include multiple clock nodes. DIV represents clock division, and is configured to convert a higher clock frequency into a lower frequency for use by other circuits in the integrated circuit. The method for monitoring a clock network in an integrated circuit in this disclosure may be implemented by using an apparatus for monitoring a clock network in an integrated circuit in this disclosure. Specifically, a clock frequency status of a first clock node in the clock network in the integrated circuit may be monitored; a clock running status of a second clock node in the clock network may be detected; and a running status of the clock network may be determined based on the clock frequency status of the first clock node and the clock running status of the second clock node. Moreover, when the running status of the clock network is abnormal, clock exception information, an interrupt signal, and the like may be output to enable an external module to process the clock network in a timely manner to restore the running status of the clock network, thereby ensuring normal running of the clock network, and thus ensuring functional safety of the integrated circuit. According to method in this disclosure, clock frequency status monitoring may be performed on only some clock nodes (for example, one or more first clock nodes) in the clock network, while clock running status detection may be performed on other clock nodes. The clock running status indicates whether the clock node is toggling normally. The clock frequency status usually needs to be implemented by using a high-precision clock frequency monitoring circuit, which needs to monitor a specific frequency of the clock node. Compared to the clock frequency status monitoring, the clock running status detection can be achieved with fewer on-chip resources. Therefore, according to the method in the embodiments of this disclosure, resource consumption for clock monitoring may be effectively reduced while full-coverage monitoring for clocks in the clock network is supported. This helps to resolve a problem of large resource consumption in a full-coverage monitoring mode in related technologies.

### Exemplary method

FIG. 2 is a schematic flowchart of a method for monitoring a clock network in an integrated circuit according to an exemplary embodiment of this disclosure. This embodiment may be applicable to an electronic device, such as a vehicle-mounted computing platform, a mobile phone, a computer, a server, and other electronic devices that require clock networks. As shown in FIG. 2, the method in this embodiment of this disclosure may include the following steps.

Step 201. Monitor a clock frequency status of a first clock node in a clock network in the integrated circuit.

The integrated circuit may be any circuit that uses a clock network to provide clocks, such as a chip with various functions on a vehicle-mounted terminal. The clock network may include multiple clock nodes, and the first clock node may be any clock node in the clock network, which is not specifically limited. There may be one or more first clock nodes. It may be understood that a quantity of the first clock nodes is less than a total quantity of clock nodes in the clock network. The clock frequency status of each first clock node may be monitored. The clock frequency status may include two states: frequency normal and frequency anomaly.

In some optional embodiments, the clock frequency status of the first clock node may be monitored by using a high-precision clock frequency monitoring circuit (which is also referred to as a clock frequency monitoring module). The clock frequency monitoring circuit may be implemented through any feasible circuit structure. For example, the clock frequency monitoring circuit may include a reference clock, a register, a counter, and a comparator. A specific circuit is not limited. The clock frequency monitoring circuit may count a quantity of reference clock cycles and a quantity of clock cycles of the first clock node within preset duration, and determine the clock frequency status of the first clock node based on a counting result. For example, a ratio of the quantity of the reference clock cycles to the quantity of the clock cycles of the first clock node may be calculated, and the ratio may be compared with a reference value to determine the clock frequency status of the first clock node based on a comparison result. Alternatively, the quantity of the clock cycles of the first clock node within the preset duration is counted based on the reference clock, and a counting result is compared with a reference threshold to determine the clock frequency status of the first clock node based on a comparison result. Alternatively, a quantity of cycles of the reference clock may be counted based on certain duration of the first clock node, and the clock frequency status of the first clock node may be determined based on a counting result. A principle for determining the clock frequency status of the first clock node is mainly that a frequency relationship between the first clock node and the reference clock should be determined. For example, if a frequency of the reference clock is 100 MHz and a frequency of the first clock node is 1 GHz, during running of the clock network, if the clock network is running normally, a ratio of the frequency of the reference clock to the frequency of the first clock node needs to remain unchanged or a variation needs to be within an error range.

Step 202. Detect a clock running status of a second clock node in the clock network.

The second clock node may include other clock nodes in the clock network except the first clock node. In other words, each other clock node in the clock network except the first clock node may be considered as a second clock node. The clock running status of each second clock node may be detected. The clock running status may include a normal status and an abnormal status. The clock running status may indicate whether a clock signal of the second clock node toggles normally.

In some optional embodiments, the first clock node may also be used as a second clock node, which is not specifically limited.

In some optional embodiments, the clock running status of the second clock node may be detected by using a clock running detection circuit (which is also referred to as a clock running detection module). The clock running detection circuit may be implemented through any feasible circuit structure, and may periodically detect clock signal toggling of the second clock node to determine the clock running status of the second clock node. For example, the clock running detection circuit may include edge detection logic, a register, and a comparator. The specific circuit structure is not limited. The edge detection logic may detect edges (which may include a rising edge and a falling edge) of a pulse signal that triggers periodic detection. The register may record a toggling status value of the second clock node during a detection period, and the comparator may compare the toggling status value with a preset value to determine the clock running status of the second clock node based on a comparison result.

It should be noted that steps 201 and 202 are not in a sequential order.

Step 203. Determine a running status of the clock network based on the clock frequency status of the first clock node and the clock running status of the second clock node.

The running status of the clock network may include two states: normal running or abnormal running.

In some optional embodiments, if at least one of the clock frequency status of the first clock node and the clock running status of the second clock node is abnormal, it may be determined that the running status of the clock network is abnormal.

In some optional embodiments, an exception signal may be output if it is determined that the running status of the clock network is abnormal. For example, an interrupt signal may be output to a preset module in the integrated circuit that is responsible for exception handling. The preset module may be, for example, a processor (CPU) or a microcontroller (MCU) in the integrated circuit, and may respond to an interrupt and perform corresponding exception handling on the clock network, such as controlling the clock network or the integrated circuit to be reset or restarted. A specific processing mode is not limited.

According to the method for monitoring a clock network in an integrated circuit provided in the embodiments, the clock frequency status of the first clock node in the clock network in the integrated circuit may be monitored, and the clock running status of the second clock node in the clock network may be detected, so that the running status of the clock network may be determined based on the clock frequency status of the first clock node and the clock running status of the second clock node. According to method in the embodiments of this disclosure, clock frequency status monitoring may be performed on only some clock nodes (for example, one or more first clock nodes) in the clock network, while clock running status detection may be performed on other clock nodes. The clock running status indicates whether the clock node is toggling normally. The clock frequency status usually needs to be implemented by using a high-precision clock frequency monitoring circuit, which needs to monitor a specific frequency of the clock node. Compared to the clock frequency status monitoring, the clock running status detection can be achieved with fewer on-chip resources. Therefore, according to the method in the embodiments of this disclosure, resource consumption for clock monitoring may be effectively reduced while full-coverage monitoring for clocks in the clock network is supported. This helps to resolve a problem of large resource consumption in a full-coverage monitoring mode in related technologies.

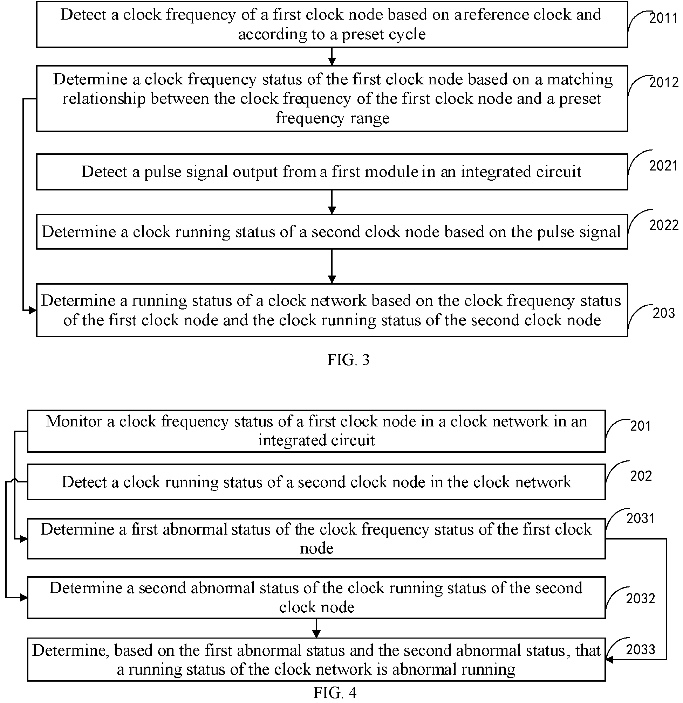

FIG. 3 is a schematic flowchart of a method for monitoring a clock network in an integrated circuit according to another exemplary embodiment of this disclosure.

In some optional embodiments, as shown in FIG. 3, step 201 of monitoring the clock frequency status of the first clock node in the clock network in the integrated circuit may include the following steps.

Step 2011. Detect a clock frequency of the first clock node based on a reference clock and according to a preset cycle.

The reference clock may be a reference clock in the clock frequency monitoring module, and the preset cycle (which may also be referred to as a first preset cycle) may be set to any cycle according to actual requirements.

In some optional embodiments, the clock frequency of the first clock node may be represented by counting a quantity of clock cycles of the first clock node within preset duration (for example, 1 second, 1 millisecond, and 1 microsecond).

Step 2012. Determine the clock frequency status of the first clock node based on a matching relationship between the clock frequency of the first clock node and a preset frequency range.

The preset frequency range may be represented by using a preset frequency upper bound and a preset frequency lower bound. For example, if the preset frequency upper bound is 1050 clock cycles and the preset frequency lower bound is 950 clock cycles, the matching relationship between the clock frequency of the first clock node and the preset frequency range may be within, less than, or greater than the preset frequency range. For example, if the clock frequency of the first clock node is greater than the preset frequency upper bound, it may be determined that the clock frequency of the first clock node is greater than the preset frequency range, which indicates that the clock frequency of the first clock node is too high, belonging to a frequency anomaly. If the clock frequency of the first clock node is less than or equal to the preset frequency upper bound and greater than or equal to the preset frequency lower bound, it may be determined that the frequency of the first clock node is normal. If the clock frequency of the first clock node is less than the preset frequency lower bound, it may be determined that the frequency of the first clock node is too slow, which also belongs to a frequency anomaly.

In the embodiments, the clock frequency of the first clock node is periodically detected, so that the specific clock frequency status of the first clock node is determined based on the matching relationship between the clock frequency of the first clock node and the preset frequency range. Thus, high-precision monitoring for the first clock node is achieved, which helps to ensure monitoring precision for the first clock node.

In some optional embodiments, as shown in FIG. 3, step 202 of detecting clock running status of the second clock node in the clock network may include the following steps.

Step 2021. Detect a pulse signal output from a first module in the integrated circuit.

The first module may be any module in the integrated circuit that can generate a pulse signal. The first module may periodically output pulse signals, which may be long pulse signals, so as to make sure that the clock running detection module can detect the pulse signal and trigger the detection of the clock running status of the second clock node. For example, the pulse signal may be in a microsecond or millisecond range, which is not specifically limited.

In some optional embodiments, the first module may be a clock frequency monitoring module or another module.

In some optional embodiments, the first module may periodically output pulse signals. An output cycle of the pulse signal may be any cycle, such as 1 millisecond or another value.

In some optional embodiments, the pulse signal is output each time after the clock frequency monitoring module determines the clock frequency status of the first clock node. For example, the clock frequency monitoring module may periodically detect a quantity of clock cycles of the first clock node within preset duration (such as 1 millisecond or 1 microsecond) to determine the clock frequency status of the first clock node. When the detection of the clock frequency status of the first clock node ends, the pulse signal is output to trigger the detection of the clock running status of the second clock node. In this way, the detection of the clock running status of the second clock node may be associated with the detection of the clock frequency status of the first clock node. For example, when the clock is turned off, the detection of the clock frequency status of the first clock node may be automatically stopped, so as to stop outputting the pulse signal to the clock running detection module. In this way, the detection of the clock running status of the second clock node may be stopped, thereby preventing the clock operation detection module from reporting an error because no clock signal toggling is detected.

Step 2022. Determine the clock running status of the second clock node based on the pulse signal.

In some optional embodiments, a status toggling situation of the clock signal of the second clock node within an effective status of the pulse signal may be detected based on the pulse signal, and the clock running status of the second clock node may be determined based on the toggling situation.

In the embodiments, the first module periodically outputs the pulse signal, so that the detection of the clock running status of the second clock node may be triggered based on the pulse signal, thereby achieving simple and effective monitoring for the second clock node. This helps to reduce resource consumption of the integrated circuit by monitoring the second clock node, thereby reducing resource consumption for monitoring the entire clock network.

In some optional embodiments, step 2022 of determining the clock running status of the second clock node based on the pulse signal may include:

determining a clock toggling status of the second clock node at a rising edge of the pulse signal; and determining, at a falling edge of the pulse signal, the clock running status of the second clock node based on the clock toggling status of the second clock node.

The clock toggling status may include two statuses: toggled and non-toggled. Different statuses may be represented by using different status values, such as 1 for toggled and 0 for non-toggled. If the clock toggling status is toggled, it may be determined that the clock running status of the second clock node is a normal status. If the clock toggling status is non-toggled, it may be determined that the clock running status of the second clock node is an abnormal status.

In some optional embodiments, when the rising edge of the pulse signal is detected, sampling of the clock signal of the second clock node may be triggered to determine a level status of the clock signal of the second clock node. The clock toggling status of the second clock node is determined based on the level status of the clock signal of the second clock node. For example, if it is determined that the level status of the clock signal of the second clock node changes from a low level to a high level, it indicates that toggling has occurred, that is, the clock toggling status of the second clock node has toggled. In this case, it may be determined that the clock running status of the second clock node is a normal status. If it is determined that the clock signal of the second clock node remains at a low level, it indicates that the clock signal of the second clock node does not toggle. In this case, it may be determined that the clock running status of the second clock node is an abnormal status.

In some optional embodiments, the determining a clock toggling status of the second clock node at a rising edge of the pulse signal may include: at the rising edge of the pulse signal, if it is detected that the second clock node toggles, setting a value of a status register to a preset value. The preset value indicates that the clock toggling status of the second clock node is normal toggling.

The determining, at a falling edge of the pulse signal, the clock running status of the second clock node based on the clock toggling status of the second clock node may include: detecting the value of the status register at the falling edge of the pulse signal; and determining the clock running status of the second clock node based on a correspondence between the value of the status register and the preset value.

An initial value of the status register may be set to a preset reset value (also referred to as an initial value), such as 0. Before the rising edge of the pulse signal arrives, the value of the status register remains at the reset value. At the rising edge of the pulse signal, if it is detected that the second clock node toggles, the value of the status register is set to the preset value. For example, the preset value is 1, that is, the status register value toggles from 0 to 1. Therefore, the value 1 of the status register may indicate that the clock toggling status of the second clock node is normal toggling. If it is detected that the second clock node has not toggled, the value of the status register is kept an initial reset value. After toggling to the preset value, the value of the status register is kept unchanged before the falling edge of the pulse signal arrives. At the falling edge of the pulse signal, the toggling status of the second clock node may be determined by detecting the value of the status register, so as to determine the clock running status of the second clock node. Specifically, the clock running status of the second clock node may be determined based on the correspondence between the value of the status register and the preset value. For example, the value of the status register may be compared with the preset value. If the value of the status register is equal to the preset value, it is determined that the clock running status of the second clock node is a normal status.

In some optional embodiments, the rising edge of the pulse signal may be detected through rising edge detection logic. The falling edge of the pulse signal may be detected through falling edge detection logic. The comparison between the value of the status register and the preset value may be achieved through a comparator.

In the embodiments, the rising edge and the falling edge of the pulse signal are detected, so that the toggling status is recorded at the rising edge of the pulse signal through the status register, and it is determined at the falling edge whether the second clock node has toggled. Since the rising edge and the falling edge can characterize effective duration of detecting whether the second clock node is toggled, if the second clock node is toggled within the effective duration between the rising edge and the falling edge, the status register can toggle to the preset value. In this case, it may be determined at the falling edge that the second clock node has toggled, and thus it may be determined that the second clock node is in a running status. If the second clock node does not toggle during the effective duration of the pulse signal because the second clock node is stuck or has a low frequency, the value of the status register would not toggle but remains at the initial value. At the falling edge, it may be determined based on the value of the status register that the second clock node has not toggled for a long time, thereby determining that the second clock node is running abnormally. Therefore, the clock running status of the second clock node may be effectively determined, helping to improve effectiveness and reliability of the clock running status of the second clock node. Anomalies in the second clock node may be found in a shorter period of time through the effective duration of the periodic pulse signal, so that the anomalies may be reported in a timely manner at the falling edge of the pulse signal, and the running status of the second clock node may be restored in a timely manner.

In some optional embodiments, after the determining the clock running status of the second clock node based on a correspondence between the value of the status register and the preset value, the method further includes: in response to that the clock running status of the second clock node is a normal status, resetting the value of the status register.

If the clock running status of the second clock node is a normal status, it indicates that the second clock node is running normally, without outputting an abnormal signal, or outputting a signal indicating normal and resetting the value of the status register. For example, the value of the status register is reset from the preset value (such as 1) to the initial value (such as 0), so that the status register may continue to be used for a next clock running status detection.

In the embodiments, resetting the value of the status register when the clock running status of the second clock node is a normal status helps to enable the status register to be used for periodic detection of the clock running status of the second clock node, thereby ensuring continuous and effective monitoring for the clock network.

FIG. 4 is a schematic flowchart of a method for monitoring a clock network in an integrated circuit according to still another exemplary embodiment of this disclosure.

In some optional embodiments, as shown in FIG. 4, step 203 of determining the running status of the clock network based on the clock frequency status of the first clock node and the clock running status of the second clock node may include the following steps.

Step 2031. Determine a first abnormal status of the clock frequency status of the first clock node.

The first abnormal status may be determined if the clock frequency status of any first clock node is a frequency anomaly. The first abnormal status may be represented in any way.

Step 2032. Determine a second abnormal status of the clock running status of the second clock node.

The second abnormal status may be determined if the clock running status of any second clock node is an abnormal status.

Step 2033. Determine, based on the first abnormal status and the second abnormal status, that the running status of the clock network is abnormal running.

Based on any one of the first abnormal status and the second abnormal status, it may be determined that the running status of the clock network is abnormal running.

In some optional embodiments, the first abnormal status of the clock frequency status of the first clock node and the second abnormal status of the clock running status of the second clock node may be determined through a data selector, an OR logic device, or the like. For example, through the data selector, an exception signal indicating the first abnormal status is output when the clock frequency status of the first clock node is an abnormal status, and an exception signal indicating the second abnormal status is output when the clock running status of the second clock node is an abnormal status, so as to determine which part of clock nodes in the clock network are running abnormally. For another example, an exception signal indicating that the clock network is running abnormally may be output through the OR logic device when at least one of the following occurs: the clock frequency status of the first clock node is an abnormal status (that is, a frequency anomaly) and the clock running status of the second clock node is an abnormal status.

In the embodiments, through the first abnormal status of the clock frequency status of the first clock node and the second abnormal status of the clock running status of the second clock node, it is determined that the running status of the clock network is abnormal running. Since the first clock node and the second clock node may cover all nodes in the clock network, the first abnormal status may be determined when the clock frequency status of any first clock node is a frequency anomaly, and the second abnormal status may be determined when the clock running status of any second clock node is an abnormal status. Therefore, when any clock node in the clock network has an anomaly, the anomaly of the clock network may be detected in a timely manner, so as to restore the normal running of the clock network in a timely manner, thereby achieving full-coverage monitoring for the clock network with less resource consumption.

In some optional embodiments, when it is determined that the running status of the clock network is abnormal running, the method in the embodiments of this disclosure may further include: resetting the clock network or the integrated circuit.

In some optional embodiments, when it is determined that the clock frequency status of the first clock node is an abnormal status, the method in the embodiments of this disclosure may further include: detecting the clock frequency status of the first clock node again.

In some optional embodiments, when it is determined that the clock running status of the second clock node is an abnormal status, the method in the embodiments of this disclosure may further include: detecting the clock running status of the second clock node again.

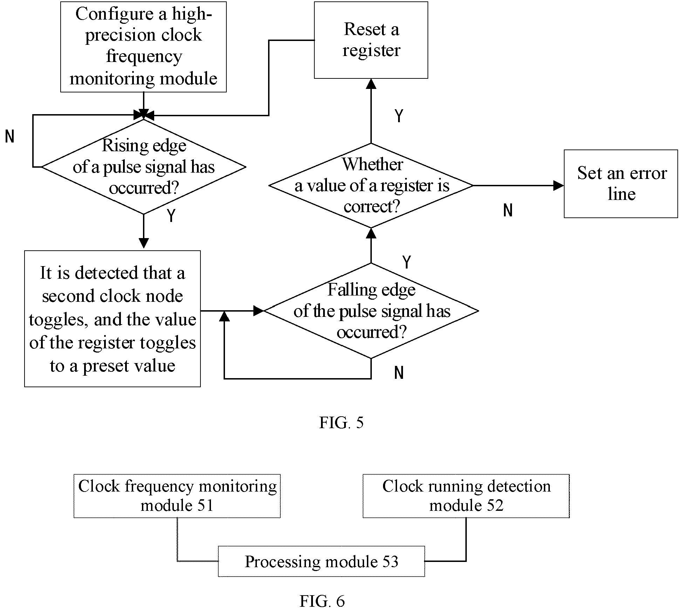

In some optional embodiments, FIG. 5 is a flow block diagram of detecting a clock running status according to an exemplary embodiment of this disclosure. As shown in FIG. 5, the first module outputting the pulse signal may be the clock frequency monitoring module. A high-precision clock frequency monitoring module may be pre-configured through software, so that the clock frequency monitoring module can monitor the clock frequency status of the first clock node, and periodically output the pulse signal. The clock running detection module may detect occurrence of the rising edge of the pulse signal, and may continue to detect whether the rising edge has occurred if the rising edge of the pulse signal has not occurred, or detect whether the second clock node toggles if the rising edge of the pulse signal has occurred. If the second clock node toggles, a value of a register (that is, the status register) is set to the preset value (such as 1). If the second clock node does not toggle, the value of the register remains unchanged (such as 0). Subsequently, it is detected whether the falling edge of the pulse signal has occurred. If the falling edge has not occurred, detection is continued. If the falling edge has occurred, it is detected whether the value of the register is correct (that is, whether this value is the preset value). If the value is incorrect, it indicates that the clock running status of the second clock node is an abnormal status. In this case, an error line may be set to output an exception signal. If the value of the register is correct, it indicates that the clock running status of the second clock node is a normal status. In this case, the register may be reset and wait for next occurrence of the rising edge of the pulse signal, so as to detect the clock running status again. The others may be deduced by analogy, to achieve high-precision monitoring for the first clock node and periodic detection for the clock running status of the second clock node. In this way, the normal running of the clock network is ensured, thereby ensuring functional safety of the integrated circuit.

According to the method in the embodiments of this disclosure, due to consistent clock sources of all clock nodes in the clock network, high-precision monitoring is performed on one or some of the clock nodes. A too large frequency error may be found in a timely manner once occurring. The clock running status detection mode is adopted to protect a large quantity of other clock nodes, so as to ensure, with the lowest resource consumption, that these clock nodes can be detected in a timely manner when these clock nodes hang up (or are stuck) or the frequency is too low, thereby effectively reducing resource consumption for monitoring while ensuring basic navigation of full-coverage monitoring for the clock network.

The foregoing embodiments of this disclosure may be implemented separately or in any combination without conflict. This may be specifically set according to actual requirements, and is not limited in this disclosure.

Any method for monitoring a clock network in an integrated circuit provided in the embodiments of this disclosure may be implemented by any suitable device with a data processing capability, including but not limited to a terminal device and a server. Alternatively, any method for monitoring a clock network in an integrated circuit provided in the embodiments of this disclosure may be implemented by a processor. For example, the processor implements any method for monitoring a clock network in an integrated circuit provided in the embodiments of this disclosure by invoking corresponding instructions stored in a memory. Details are not described below.

### Exemplary apparatus

FIG. 6 is a schematic diagram of a structure of an apparatus for monitoring a clock network in an integrated circuit according to an exemplary embodiment of this disclosure. The apparatus in this embodiment may be configured to implement the corresponding method embodiments of this disclosure. The apparatus shown in FIG. 6 may include a clock frequency monitoring module 51, a clock running detection module 52, and a processing module 53.

The clock frequency monitoring module 51 may be configured to monitor a clock frequency status of a first clock node in a clock network in the integrated circuit.

The clock running detection module 52 may be configured to detect a clock running status of a second clock node in the clock network.

The processing module 53 is connected to the clock frequency monitoring module 51 and the clock running detection module 52, and is configured to determine a running status of the clock network based on the clock frequency status of the first clock node and the clock running status of the second clock node.

For specific functions of the foregoing modules, reference may be made to the foregoing corresponding method embodiments, and details are not described herein.

In some optional embodiments, the foregoing modules may be implemented through software, hardware, or a combination of software and hardware, which is not specifically limited. To ensure real-time monitoring for the clock network, the foregoing modules may be implemented through hardware. For example, the clock frequency monitoring module 51 may be implemented through a high-precision clock frequency monitoring circuit (such as a reference clock, a counter, a register, and a comparator). The clock running detection module 52 may be implemented through a simple and effective clock running detection circuit (such as edge detection logic, a register, and a comparator). The processing module 53 may be implemented through a processing logic circuit (such as a data selector, a OR logic device).

In some optional embodiments, according to a quantity of first clock nodes, the apparatus in the embodiments of this disclosure may include one or more clock frequency monitoring modules 51. Each first clock node may be connected to one corresponding clock frequency monitoring module 51. The first clock nodes may be in one-to-one correspondence to the clock frequency monitoring modules 51. Similarly, according to a quantity of second clock nodes, the apparatus in the embodiments of this disclosure may include clock running detection modules 52 corresponding to all second clock nodes. In this way, full-coverage monitoring for the clock nodes in the clock network of the integrated circuit is achieved.

In some optional embodiments, the clock frequency monitoring module 51 may include monitoring units respectively corresponding to all first clock nodes, thereby achieving monitoring for the clock frequency status of each first clock node. The clock running detection module 52 may include detection units respectively corresponding to all second clock nodes, thereby achieving monitoring for the clock running status of each second clock node.

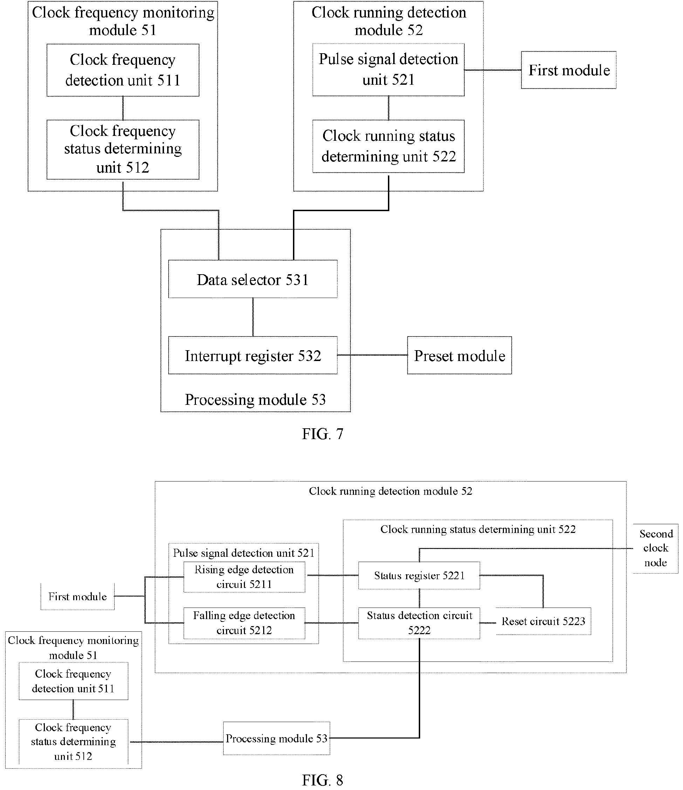

FIG. 7 is a schematic diagram of a structure of an apparatus for monitoring a clock network in an integrated circuit according to another exemplary embodiment of this disclosure.

In some optional embodiments, as shown in FIG. 7, the clock frequency monitoring module 51 may include a clock frequency detection unit 511 and a clock frequency status determining unit 512.

The clock frequency detection unit 511 may be configured to detect a clock frequency of the first clock node based on a reference clock and according to a preset cycle.

In some optional embodiments, the clock frequency detection unit 511 may include a reference clock, a counter, a register, and the like.

The clock frequency status determining unit 512 is connected to the clock frequency detection unit 511 and the processing module 53, and may be configured to determine the clock frequency status of the first clock node based on a matching relationship between the clock frequency of the first clock node and a preset frequency range.

The clock frequency status determining unit 512 may also be configured to output a frequency anomaly signal to the processing module 53 in response to that it is determined that the clock frequency status of the first clock node is a frequency anomaly.

In some optional embodiments, the clock frequency status determining unit 512 may include a comparator to compare the clock frequency of the first clock node with a boundary value of the preset frequency range.

In some optional embodiments, as shown in FIG. 7, the clock running detection module 52 may include a pulse signal detection unit 521 and a clock running status determining unit 522.

The pulse signal detection unit 521 is connected to a first module that generates a pulse signal, and may be configured to detect the pulse signal output from the first module.

In some optional embodiments, the pulse signal detection unit 521 may include edge detection logic to detect an effective pulse of the pulse signal. The edge detection logic may be implemented through any feasible circuit structure. For example, the edge detection logic may include a two-stage flip-flop, an inverter, and a AND logic device. A specific circuit structure is not limited.

The clock running status determining unit 522 may be connected to the pulse signal detection unit 521, and may be configured to determine the clock running status of the second clock node based on the pulse signal.

In some optional embodiments, the clock running status determining unit 522 may sample, based on the pulse signal, a toggling status of a clock signal of the second clock node during an effective pulse period of the pulse signal, so as to determine the clock running status of the second clock node based on the toggling status.

FIG. 8 is a schematic diagram of a structure of an apparatus for monitoring a clock network in an integrated circuit according to still another exemplary embodiment of this disclosure.

In some optional embodiments, as shown in FIG. 8, the pulse signal detection unit 521 may include a rising edge detection circuit 5211 and a falling edge detection circuit 5212.

The rising edge detection circuit 5211 is connected to the first module and the clock running status determining unit 522, and may be configured to output a first trigger signal to the clock running status determining unit 522 at a rising edge of the pulse signal.

The first trigger signal may be a high-level signal. After detecting the rising edge of the pulse signal, the rising edge detection circuit 5211 outputs the high-level first trigger signal to the clock running status determining unit 522, to trigger the clock running status determining unit 522 to sample the toggling status of the clock signal of the second clock node.

The falling edge detection circuit 5212 may be connected to the first module and the clock running status determining unit 522, and may be configured to output a second trigger signal to the clock running status determining unit 522 at a falling edge of the pulse signal.

The second trigger signal may be a high-level signal. When detecting the falling edge of the pulse signal, the falling edge detection circuit 5212 outputs the high-level second trigger signal to the clock running status determining unit 522.

The clock running status determining unit 522 may be configured to determine the clock toggling status of the second clock node in response to the first trigger signal.

The clock running status determining unit 522 is triggered by the first trigger signal to sample the toggling status of the clock signal of the second clock node. If the clock signal of the second clock node is toggled, it may be determined that the clock signal of the second clock node is toggled, or otherwise, the clock signal is not toggled.

The clock running status determining unit 522 may also be configured to determine, in response to the second trigger signal, the clock running status of the second clock node based on the clock toggling status of the second clock node.

The clock running status determining unit 522 is triggered by the second trigger signal to determine the clock running status of the second clock node based on the clock toggling status of the second clock node. If toggling occurs, it is determined that the clock running status of the second clock node is a normal status. Otherwise, it is determined that the clock running status is an abnormal status.

In some optional embodiments, the clock running status determining unit 522 may include a status register 5221 and a status detection circuit 5222.

The status register 5221 may be connected to the rising edge detection circuit 5211 and the second clock node, and may be configured to respond to the first trigger signal. If the second clock node toggles, a value of the status register toggles to a preset value.

The toggling of the second clock node may refer to a change in a level status of the clock signal of the second clock node. For example, the clock signal of the second clock node is toggled from a low level to a high level.

In some optional components, the first trigger signal and the clock signal are used as inputs for the status register. When the first trigger signal is at a high level, the clock signal toggles from a low level to a high level, to trigger the value of the status register to toggle from an initial value of 0 to a preset value of 1.

The status detection circuit 5222 may be connected to the falling edge detection circuit 5212, the status register 5221, and the processing module 53; and may be configured to detect the value of the status register 5221 in response to the second trigger signal, and determine the clock running status of the second clock node based on a correspondence between the value of the status register 5221 and the preset value.

The status detection circuit 5222 may also be configured to output a running status anomaly signal to the processing module 53 in response to determining that the clock running status of the second clock node is an abnormal status.

In some optional embodiments, the status detection circuit 5222 may include a comparator and a reference register. Output of the falling edge detection circuit 5212 serves as working enable input for the comparator. The status register 5221 is connected to one input end of the comparator. The reference register stores a preset value, and is connected to another input end of the comparator. Under action of the second trigger signal, the comparator works to compare the value of the status register 5221 with the preset value of the reference register, and outputs the clock running status of the second clock node based on a comparison result. For example, 0 is output to indicate abnormal and 1 is output to indicate normal, or 0 is output to indicate normal and 1 is output to indicate abnormal.

In some optional embodiments, as shown in FIG. 8, the clock running status determining unit 522 may further include a reset circuit 5223.

The reset circuit 5223 may be connected to the status detection circuit 5222 and the status register 5221, and may be configured to reset the value of the status register 5221 in response to that it is determined that the clock running status of the second clock node is a normal status.

The reset circuit 5223 may be implemented by using any feasible logic circuit. The reset circuit 5223 may output a reset signal (which is also referred to as a re-set signal) to the status register 5221 when it is determined that the clock running status of the second clock node is a normal status, to control the status register 5221 to be reset. For example, an output end of the reset circuit 5223 is connected to a reset pin of the status register 5221, and the reset signal is output to the status register 5221 through the reset pin. After receiving the reset signal, the status register 5221 resets an internal value to zero and returns to an initial value. A specific reset manner is not limited to the foregoing manner.

In some optional embodiments, as shown in FIG. 7, the processing module 53 may include a data selector 531 and an interrupt register 532.

The data selector 531 may be configured to output an abnormal status signal in response to the first abnormal status of the clock frequency status of the first clock node and the second abnormal status of the clock running status of the second clock node.

The abnormal status signal may be a high-level signal or a low-level signal, which is not specifically limited.

In some optional embodiments, the data selector may be an either-or selector. The abnormal status signal is output when either the clock frequency status of the first clock node or the clock running status of the second clock node is abnormal.

The interrupt register 532 may be connected to the data selector 531, and may be configured to output an interrupt signal to a preset module of the integrated circuit based on the abnormal status signal.

The preset module may be a processor (CPU) or a microcontroller (MCU) in a basic circuit that can respond to interrupts and perform exception handling on the clock network. This is not specifically limited.

In some optional embodiments, the preset module may respond to the interrupt signal to reset the clock network or the integrated circuit, so as to restore the running status of the clock network.

In some optional embodiments, the interrupt register 532 may also be configured to output a first indication signal to the clock frequency monitoring module 51 in response to that the clock frequency status of the first clock node is an abnormal status, to instruct the clock frequency monitoring module 51 to detect the clock frequency status of the first clock node again. If the clock frequency status of the first clock node that is obtained through re-detection is normal, error handling may be temporarily omitted while the monitoring of the clock frequency status of the first clock node may be continued. If the clock frequency status of the first clock node that is obtained through re-detection is an abnormal status, resetting and other processing may be performed on the clock network or the integrated circuit.

In some optional embodiments, the interrupt register 532 may also be configured to output a second indication signal to the clock running detection module 52 in response to that the clock running status of the second clock node is an abnormal status, to instruct the clock running detection module 52 to detect the clock running status of the second clock node again. Subsequent processing manners are determined based on a re-detection result. For example, if a re-detection result is still an abnormal status, resetting and other processing may be performed on the clock network or the integrated circuit.

In some optional embodiments, for multiple first clock nodes, the apparatus in the embodiments of this disclosure may further include a first OR logic unit that is configured to perform OR logic operations on output of the clock frequency monitoring module 51 corresponding to each first clock node. When the clock frequency status of any first clock node is abnormal (which is, for example, represented by 1), an exception signal is output to the processing module 53.

In some optional embodiments, for multiple second clock nodes, the apparatus in the embodiments of this disclosure may further include a second OR logic unit that is configured to perform OR logic running on output of the clock running detection module 52 corresponding to each second clock node. When the clock running status of any second clock node is abnormal (which is, for example, represented by 1), an exception signal is output to the processing module 53.

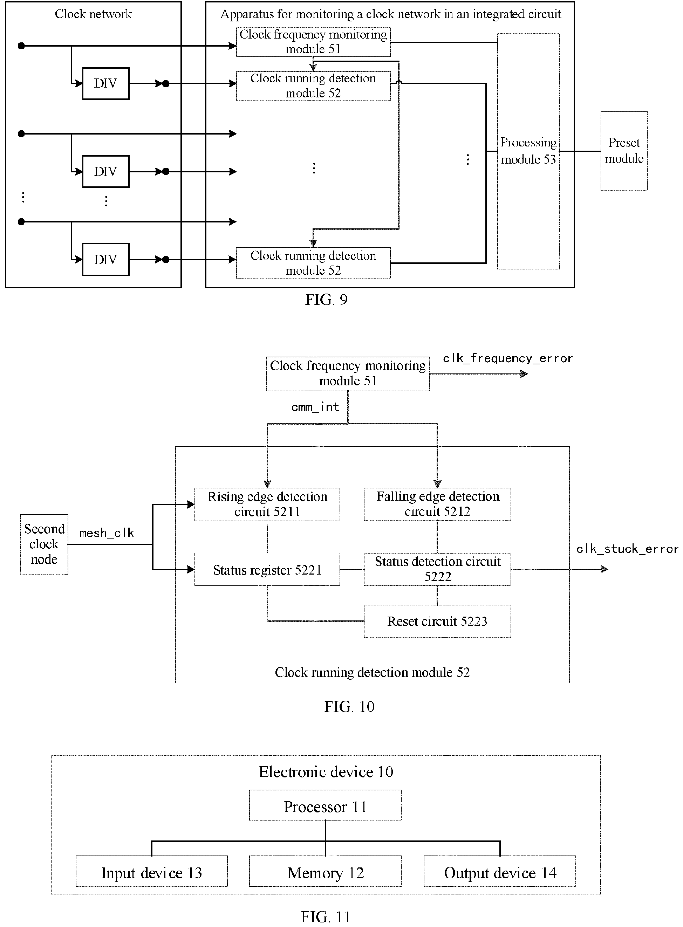

In some optional embodiments, FIG. 9 is a schematic diagram of a structure of an apparatus for monitoring a clock network in an integrated circuit according to an exemplary implementation in an exemplary embodiment of this disclosure. As shown in FIG. 9, any one or more clock nodes in the clock network may be used as the first clock nodes. In FIG. 9, an example in which one clock node is used as the first clock node is used, and the clock frequency status of the first clock node is monitored by using the clock frequency monitoring module 51. Other clock nodes in the clock network except the first clock node are used as second clock nodes, and each second clock node may correspond to one clock running detection module 52. The clock running status of the second clock node may be detected by using the clock running detection module 52. As the first module that generates pulse signals, the clock frequency monitoring module 51 provides periodic pulse signals for each clock running detection module 52. The clock frequency monitoring module 51 and each clock running detection module 52 are connected to the processing module 53, respectively. Alternatively, each clock running detection module may be connected to the processing module 53 through an OR logic circuit or a data selector, to output the clock frequency status of the first clock node and the clock running status of the second clock node to the processing module 53. The processing module 53 may determine the running status of the clock network based on the clock frequency status of the first clock node and the clock running status of the second clock node. When an exception occurs to the running status of the clock network, an interrupt signal is output to the preset module, so that the preset module is enabled to perform exception handling on the clock network or the integrated circuit in a timely manner, so as to restore the running status of the clock network.

In some optional embodiments, FIG. 10 is a schematic diagram of a structure of a clock running detection module 52 according to an exemplary implementation in an exemplary embodiment of this disclosure. As shown in FIG. 10, for any second clock node, mesh_clk represents a clock signal output from the second clock node. While monitoring the clock frequency status of the first clock node (outputting a frequency anomaly signal clk_frequency_error when the frequency is abnormal), the clock frequency monitoring module 51 may output the pulse signal (that is, cmm_int in FIG. 10) according to a certain cycle based on a reference clock of the clock frequency monitoring module 51. The clock signal of the second clock node may provide working clock for the rising edge detection circuit 5211 and the status register 5221, and may also provide working clock for other circuits that require working clock. The rising edge detection circuit 5211 outputs the first trigger signal to the status register 5221 under action of the pulse signal and the clock signal. The status register 5221 toggles or maintains an original value based on the first trigger signal and the clock signal. For example, if the first trigger signal and the clock signal are at a high level (or 1), the value of the status register 5221 toggles to a preset value, such as toggling from 0 to 1, indicating that the second clock node toggles normally. If either the first trigger signal or the clock signal is at a low level, the value of the status register 5221 does not toggle but remains at the reset value (such as 0), indicating that the pulse signal has not reached the rising edge or the clock signal of the second clock node has not toggled. After detecting the rising edge of the pulse signal, the falling edge detection circuit 5212 may detect the falling edge of the pulse signal constantly. At the falling edge of the pulse signal, the falling edge detection circuit 5212 may output a second trigger signal (such as a high-level signal or 1) to the status detection circuit 5222, which may respond to the second trigger signal to detect the value of the status register, and compare the value of the status register with the preset value. If the value of the status register 5221 is the preset value, it may be determined that the second clock node has toggled normally, and thus it is determined that the clock running status of the second clock node is a normal status. If the value of the status register 5221 is not the preset value, it may be determined that the second clock node has not toggled, and thus it may be determined that the clock running status of the second clock node is an abnormal status. In this case, the status detection circuit 5222 may output a running status anomaly signal (that is, clk_stuck_error in FIG. 10) to the processing module 53. If the status detection circuit 5222 determines that the clock running status of the second clock node is a normal status, a reset trigger signal may be output to the reset circuit 5223. In response to the reset trigger signal, the reset circuit 5223 outputs a reset signal to the status register 5221, to reset the value of the status register 5221 to the reset value (such as 0). Each second clock node in the clock network may periodically detect the clock running status according to the foregoing detection process. The first clock node in the clock network detects the clock frequency status by using the high-precision clock frequency monitoring module 51, thereby achieving full-coverage monitoring of the clock network while ensuring local monitoring accuracy, and reducing resource consumption during the monitoring process.

For beneficial technical effects corresponding to the exemplary embodiments of this apparatus, reference may be made to the corresponding beneficial technical effects in the section of exemplary method described above, and details are not described herein again.

### Exemplary electronic device

FIG. 11 is a diagram of a structure of an electronic device according to an embodiment of this disclosure. The electronic device includes at least one processor 11 and a memory 12.

The processor 11 may be a central processing unit (CPU) or another form of processing unit having a data processing capability and/or an instruction execution capability, and may control other components in the electronic device 10 to implement desired functions.

The memory 12 may include one or more computer program products, which may include various forms of computer readable storage media, such as a volatile memory and/or a non-volatile memory. The volatile memory may include, for example, a random access memory (RAM) and/or a cache. The non-volatile memory may include, for example, a read-only memory (ROM), a hard disk, and a flash memory. One or more computer program instructions may be stored on the computer readable storage medium. The processor 11 may execute the one or more program instructions to implement the method according to the various embodiments of this disclosure that are described above and/or other desired functions.

In an example, the electronic device 10 may further include an input device 13 and an output device 14. These components are connected to each other through a bus system and/or another form of connection mechanism (not shown).

The input device 13 may further include, for example, a keyboard and a mouse.

The output device 14 may output various information to the outside, and may include, for example, a display, a speaker, a printer, a communication network, and a remote output device connected to the communication network.

Certainly, for simplicity, FIG. 11 shows only some of components in the electronic device 10 that are related to this disclosure, and components such as a bus and an input/output interface are omitted. In addition, according to specific application situations, the electronic device 10 may further include any other appropriate components.

In some optional embodiments, embodiments of this disclosure may further provide an electronic device, which includes the apparatus for monitoring a clock network in an integrated circuit according to any one of the foregoing embodiments of this disclosure.

### Exemplary computer program product and computer readable storage medium

In addition to the foregoing method and device, the embodiments of this disclosure may also provide a computer program product, which includes computer program instructions. When the computer program instructions are executed by a processor, the processor is enabled to perform the steps, of the method according to the embodiments of this disclosure, that are described in the "exemplary method" section described above.

The computer program product may be program code, written with one or any combination of a plurality of programming languages, that is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by the processor, the processor is enabled to perform the steps, of the method according to the embodiments of this disclosure, that are described in the "exemplary method" section described above.

The computer readable storage medium may be one readable medium or any combination of a plurality of readable media. The readable medium may be a readable signal medium or a readable storage medium. The readable storage medium includes, for example but is not limited to electricity, magnetism, light, electromagnetism, infrared ray, or a semiconductor system, an apparatus, or a device, or any combination of the above. More specific examples (a non-exhaustive list) of the readable storage medium include: an electrical connection with one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, advantages, superiorities, and effects mentioned in this disclosure are merely examples but are not for limitation, and it cannot be considered that these advantages, superiorities, and effects are necessary for each embodiment of this disclosure. In addition, specific details described above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. A method for monitoring a clock network in an integrated circuit, **characterized in that** the method for monitoring a clock network in an integrated circuit comprises:
monitoring (201) a clock frequency status of a first clock node in a clock network in the integrated circuit;
detecting (202) a clock running status of a second clock node in the clock network; and
determining (203) a running status of the clock network based on the clock frequency status of the first clock node and the clock running status of the second clock node.

2. The method according to claim 1, wherein the detecting a clock running status of a second clock node in the clock network comprises:
detecting (2021) a pulse signal output from a first module in the integrated circuit; and
determining (2022) the clock running status of the second clock node based on the pulse signal.

3. The method according to claim 2, wherein the determining the clock running status of the second clock node based on the pulse signal comprises:
determining a clock toggling status of the second clock node at a rising edge of the pulse signal; and
determining, at a falling edge of the pulse signal, the clock running status of the second clock node based on the clock toggling status of the second clock node.

4. The method according to claim 3, wherein the determining a clock toggling status of the second clock node at a rising edge of the pulse signal comprises:
at the rising edge of the pulse signal, if it is detected that the second clock node toggles, setting a value of a status register to a preset value, wherein the preset value indicates that the clock toggling status of the second clock node is normal toggling; and
the determining, at a falling edge of the pulse signal, the clock running status of the second clock node based on the clock toggling status of the second clock node comprises:
detecting the value of the status register at the falling edge of the pulse signal; and
determining the clock running status of the second clock node based on a correspondence between the value of the status register and the preset value.

5. The method according to claim 4, wherein after the determining the clock running status of the second clock node based on a correspondence between the value of the status register and the preset value, the method further comprises:
in response to that the clock running status of the second clock node is a normal status, resetting the value of the status register.

6. The method according to any one of claims 1 to 5, wherein the monitoring a clock frequency status of a first clock node in a clock network in the integrated circuit comprises:
detecting (2011) a clock frequency of the first clock node based on a reference clock and according to a preset cycle; and
determining (2012) the clock frequency status of the first clock node based on a matching relationship between the clock frequency of the first clock node and a preset frequency range.

7. The method according to any one of claims 1 to 5, wherein the determining a running status of the clock network based on the clock frequency status of the first clock node and the clock running status of the second clock node comprises:
determining (2031) a first abnormal status of the clock frequency status of the first clock node;
determining (2032) a second abnormal status of the clock running status of the second clock node; and
determining (2033), based on the first abnormal status and the second abnormal status, that the running status of the clock network is abnormal running.

8. An apparatus for monitoring a clock network in an integrated circuit, **characterized in that** the apparatus for monitoring a clock network in an integrated circuit comprises:
a clock frequency monitoring module (51), configured to monitor a clock frequency status of a first clock node in a clock network in the integrated circuit;
a clock running detection module (52), configured to detect a clock running status of a second clock node in the clock network; and
a processing module (53) connected to the clock frequency monitoring module and the clock running detection module, respectively, being configured to determine a running status of the clock network based on the clock frequency status of the first clock node and the clock running status of the second clock node.

9. The apparatus according to claim 8, wherein the clock running detection module comprises:
a pulse signal detection unit (521) connected to a first module that generates a pulse signal, being configured to detect the pulse signal output from the first module; and
a clock running status determining unit (522) connected to the pulse signal detection unit, being configured to determine the clock running status of the second clock node based on the pulse signal.

10. The apparatus according to claim 9, wherein the pulse signal detection unit (521) comprises a rising edge detection circuit (5211) and a falling edge detection circuit (5212),
wherein the rising edge detection circuit (5211) is connected to the first module and the clock running status determining unit (522), and is configured to output a first trigger signal to the clock running status determining unit (522) at a rising edge of the pulse signal; and
wherein the falling edge detection circuit (5212) is connected to the first module and the clock running status determining unit (522), and is configured to output a second trigger signal to the clock running status determining unit (522) at a falling edge of the pulse signal.

11. The apparatus according to claim 9, wherein the clock running status determining unit (522) comprises a status register (5221) and a status detection circuit (5222),
wherein the status register (5221) is connected to the rising edge detection circuit (5211) and the second clock node, and is configured to respond to the first trigger signal; and
wherein the status detection circuit (5222) is connected to the falling edge detection circuit (5212), the status register (5221), and the processing module (53); and is configured to detect the value of the status register (5221) in response to the second trigger signal, and determine the clock running status of the second clock node based on a correspondence between the value of the status register (5221) and the preset value.

12. The apparatus according to claim 9, wherein the processing module (53) comprises a data selector (531) and an interrupt register (532);
wherein the data selector (531) is configured to output an abnormal status signal in response to the first abnormal status of the clock frequency status of the first clock node and the second abnormal status of the clock running status of the second clock node; and
wherein the interrupt register (532) is connected to the data selector (531), and is configured to output an interrupt signal to a preset module of the integrated circuit based on the abnormal status signal.

13. The apparatus according to any one of claims 8 and 9, wherein the clock frequency monitoring module (51) comprises:
a clock frequency detection unit (511), configured to detect a clock frequency of the first clock node based on a reference clock and according to a preset cycle; and
a clock frequency status determining unit (512) connected to the clock frequency detection unit and the processing module, respectively, being configured to determine the clock frequency status of the first clock node based on a matching relationship between the clock frequency of the first clock node and a preset frequency range, wherein
the clock frequency status determining unit (512) is further configured to output a frequency anomaly signal to the processing module in response to that it is determined that the clock frequency status of the first clock node is a frequency anomaly.

14. A computer readable storage medium, **characterized in that** the storage medium stores a computer program, and the computer program is used for implementing the method according to any one of claims 1 to 7.

15. An electronic device (10), **characterized in that** the electronic device comprises:
a processor (11); and
a memory (12), configured to store processor-executable instructions, wherein
the processor (11) is configured to read the executable instructions from the memory (12), and execute the instructions to implement the method according to any one of claims 1 to 7; or
the electronic device (10) comprises the apparatus according to any one of claims 8 to 10.
